(19) Europäisches Patentamt
European Patent Office
Office européen des brevets

(11) **EP 2 720 280 A1**

(12) **EUROPEAN PATENT APPLICATION**
published in accordance with Art. 153(4) EPC

(43) Date of publication:
**16.04.2014 Bulletin 2014/16**

(51) Int Cl.:
***H01L 31/052*** *(2014.01)*

(21) Application number: **12796471.6**

(22) Date of filing: **18.05.2012**

(86) International application number:
**PCT/JP2012/003285**

(87) International publication number:
**WO 2012/169123 (13.12.2012 Gazette 2012/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.06.2011 JP 2011130574**
**17.06.2011 JP 2011135564**

(71) Applicant: **JX Nippon Oil & Energy Corporation**
**Chiyoda-ku**
**Tokyo 100-8162 (JP)**

(72) Inventors:
• **HAYASHI, Shinya**
**Tokyo 100-8162 (JP)**
• **NAKAYAMA, Keisuke**
**Tokyo 100-8162 (JP)**
• **GOTO, Masanao**
**Tokyo 100-8162 (JP)**

(74) Representative: **Algemeen Octrooi- en Merkenbureau B.V.**
**P.O. Box 645**
**5600 AP Eindhoven (NL)**

(54) **PHOTOELECTRIC CONVERSION ELEMENT**

(57)     A photoelectric conversion element 10 includes an antireflection layer 20, a photoelectric conversion layer 30, a transparent thin film layer 40, a light reflection layer 50, and a dielectric layer 60. The antireflection layer 20 is provided on a light reception surface side of the photoelectric conversion layer 30. The transparent thin film layer 40 is provided on the back surface side of the photoelectric conversion layer 30. The light reflection layer 50 is stacked on the transparent thin film layer 40 and includes a metal film 52 having penetration parts 54 penetrating from one main surface to the other main surface. The dielectric layer 60 is stacked so as to cover the light reflection layer 50.

FIG.1

LIGHT RECEPTION SIDE

10

**Description**

TECHNICAL FIELD

The present invention relates to a photoelectric conversion element for converting light energy to electric energy by photoelectric conversion.

BACKGROUND ART

Reduction in thickness of a photoelectric conversion layer in a photoelectric conversion element such as a solar cell is further desired to achieve resource saving and lower cost. However, when the thickness of the photoelectric conversion layer is simply reduced, the light absorption amount in the photoelectric conversion layer decreases, and the photoelectric conversion efficiency deteriorates. It is therefore necessary to develop a technique to increase the absorption amount in the photoelectric conversion layer.

One of such techniques is a method of fabricating a texture structure on the surface and/or the back surface of a photoelectric conversion layer to increase the optical path length in the photoelectric conversion layer by making incident light and reflection light scattered on the surface and/or the back surface of the photoelectric conversion layer. A technique of processing periodical fine structures in a photoelectric conversion element is also known. In this case, by setting a condition that light which is to pass through the photoelectric conversion layer is diffracted by the periodical fine patterns and reflected light is totally reflected in the photoelectric conversion layer, the light is confined in the photoelectric conversion layer, and the photoelectric conversion efficiency is improved.

CITATION LIST

PATENT LITERATURE

Patent Literature 1: Japanese Unexamined Patent Application Publication No. S61-288473
Patent Literature 2: Japanese Unexamined Patent Application Publication No. H4-133360
Patent Literature 3: Japanese Unexamined Patent Application Publication No. 2000-294818
Patent Literature 4: Japanese Unexamined Patent Application Publication (Translation of PCT application) No. 2009-533875

SUMMARY OF INVENTION

TECHNICAL PLOBLEM

However, in the conventional configuration of fabricating a texture structure on the surface and/or the back surface of a photoelectric conversion layer, a relatively large amount of light is leaked to the outside of the photoelectric conversion element without being reflected toward the photoelectric conversion layer. One of methods of reducing the light leaked to the outside is a method of periodically disposing texture structures. However, the cost of fabricating the periodically-disposed texture structures is high, so that it is difficult to realize lower cost of the photoelectric conversion element. Also in the case of processing the periodical fine structures in the photoelectric conversion element, similarly, the cost is high, and it becomes difficult to realize lower cost of the photoelectric conversion element.

The present invention has been achieved in view of such problems and an object of the invention is to provide a technique which can increase the light absorption rate of a photoelectric conversion layer and improve the photoelectric conversion efficiency while suppressing manufacture cost.

SOLUTION TO PROBLEM

An aspect of the present invention is photoelectric conversion element. The photoelectric conversion element includes: photoelectric conversion layer; and a light reflection layer including a metal film provided on one of main surface sides of the photoelectric conversion layer, wherein penetration parts penetrating from one main surface of the metal film to the other main surface are provided in a plurality of portions in the metal film.

In the photoelectric conversion element of the aspect, incident light which cannot be absorbed by the photoelectric conversion layer is scattered and reflected by the light reflection layer, so that the optical path length of the incident light in the photoelectric conversion layer becomes longer, and the incident light can be efficiently absorbed.

In the photoelectric conversion element of the aspect, a distance between a center of gravity in an opening on the photoelectric conversion layer side of an arbitrary penetration part and a center of gravity in an opening on the photoelectric conversion side of another penetration part adjacent to the arbitrary penetration part may be 200 nm to 400 nm. In an opening on the photoelectric conversion layer side of the penetration part, a maximum distance between two points in an inner wall of the penetration part may be 10 nm to 250 nm. A shortest distance between adjacent penetration parts may be 200 nm to 400 nm in a main surface of the metal film on the photoelectric conversion layer side. Average reflectance in a range from 400 nm to a maximum wavelength usable by the photoelectric conversion layer for power generation, of the light reflection layer may be 40% or higher.

The light reflection layer may be provided on a side opposite to a light reception surface of the photoelectric conversion layer. The metal film may be made of Au, Ag, Al, Cu, or an alloy containing any of those metals. The light reflection layer may include a mask for forming the metal film. The light reflection layer may also serve as a back-surface electrode for power collection.

Another aspect of the present invention is a photoelectric conversion element. The photoelectric conversion element includes: a photoelectric conversion layer; an antireflection layer provided on one main surface side of the photoelectric conversion layer; and a light reflection layer including a metal film provided on the other main surface side of the photoelectric conversion layer, wherein a plurality of concave parts are provided in a main surface on the side of the photoelectric conversion layer of the metal film.

In the photoelectric conversion element of the aspect, incident light which cannot be absorbed by the photoelectric conversion layer is scattered and reflected by the light reflection layer, so that the optical path length of the incident light in the photoelectric conversion layer becomes longer, and the incident light can be efficiently absorbed.

A distance between a center of gravity in an opening of an arbitrary concave part and a center of gravity in an opening of another concave part adjacent to the arbitrary concave part may be 250 nm to 400 nm.

The metal film may be made of Au, Ag, Al, Cu, or an alloy containing any of those metals. The photoelectric conversion layer may include single crystal or polycrystalline silicon having a p-n junction. The light reflection layer may include a mask for forming the metal film. The light reflection layer may also serve as a back-surface electrode for power collection.

A combination obtained by properly combining the above-described elements can be also included in the scope of the present invention requiring protection with a patent by the present patent application.

ADVANTAGEOUS EFFECTS OF INVENTION

The photoelectric conversion element of the present invention can increase the light absorption rate and improve the photoelectric conversion efficiency with lower manufacture cost.

BRIEF DESCRIPTION OF DRAWINGS

FIG. 1 is a schematic cross section illustrating a configuration of a photoelectric conversion element according to a first embodiment.

FIG. 2 is a plan view illustrating a form of a metal film when the photoelectric conversion element according to the first embodiment is seen from a light reception surface side.

FIGS. 3(A) to 3(D) are process cross sections illustrating fabricating processes of the photoelectric conversion element according to the first embodiment.

FIGS. 4(A) to 4(C) are process cross sections illustrating fabricating processes of the photoelectric conversion element according to the first embodiment.

FIG. 5 is a schematic cross section illustrating a configuration of a photoelectric conversion element according to a second embodiment.

FIG. 6 is a plan view illustrating a form of a metal film when the photoelectric conversion element according to the second embodiment is seen from a light reception surface side.

FIG. 7 is a schematic cross section illustrating a configuration of a photoelectric conversion element according to a modification.

FIG. 8 is a plan view illustrating a form of a metal film when the photoelectric conversion element according to the modification is seen from a light reception surface side.

FIGS. 9(A) to 9(C) are process cross sections illustrating fabricating processes of the photoelectric conversion element according to the second embodiment.

FIGS. 10(A) and 10(B) are process cross sections illustrating fabricating processes of the photoelectric conversion element according to the second embodiment.

DESCRIPTION OF EMBODIMENTS

Hereinafter, embodiments of the present invention will be described with reference to the drawings. In all of the drawings, similar reference numerals are designated to similar components and their description will be properly omitted.

First Embodiment

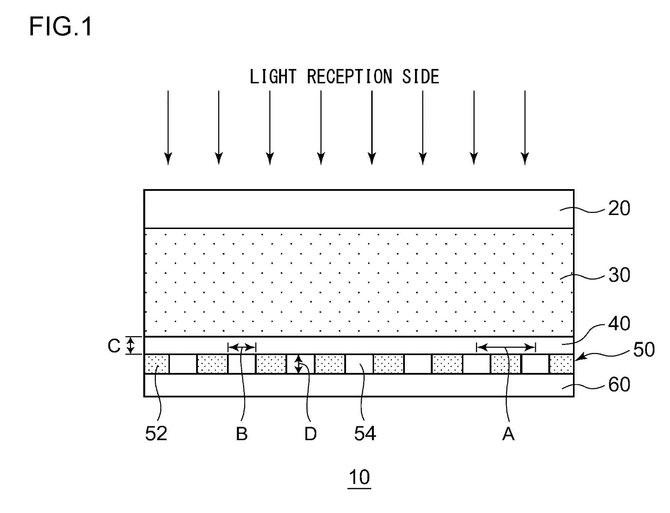

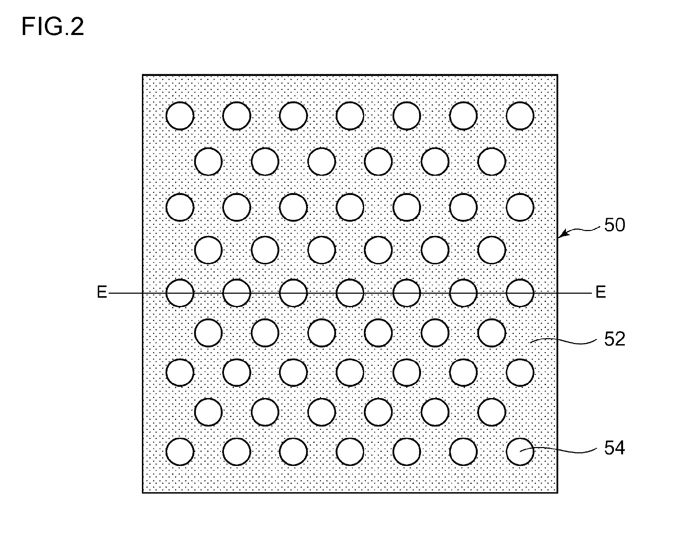

FIG. 1 is a schematic cross section illustrating a configuration of a photoelectric conversion element 10 according to a first embodiment. FIG. 2 is a plan view illustrating a form of a metal film 52 when the photoelectric conversion element 10 is seen from a light reception surface side. FIG. 1 corresponds to a cross section on the line E-E of FIG. 2. In FIG. 2, the configuration of a photoelectric conversion layer 30 and the like other than the metal film 52 is omitted. As illustrated in FIG. 1, the photoelectric conversion element has an antireflection layer 20, the photoelectric conversion layer 30, a transparent thin film layer 40, a light reflection layer 50, a dielectric layer 60, and a surface electrode (not illustrated) for power collection formed on the light reception surface side of the antireflection layer 20 and, in some cases, a back-surface electrode (not illustrated) for power collection formed on a side opposite to the light reception surface side of the dielectric layer 60. In the embodiment, the photoelectric conversion element is a solar cell.

The antireflection layer 20 is provided on the light reception surface side of the photoelectric conversion layer 30. It is sufficient for the antireflection layer 20 to have transparency in the wavelength region of light received by the photoelectric conversion layer 30 and the function of preventing reflection of light received by the photoelectric conversion layer 30. The antireflection layer 20 is preferably made of $SiO_2$, $SiN_x$, $TiO_2$, ITO, or the like, but not limited thereto.

The thickness of the antireflection layer 20 is preferably 0 to 500 nm, more preferably, 0 to 300 nm, and further more preferably, 50 to 200 nm, but not limited thereto.

For the surface electrode formed on the light reception surface side of the antireflection layer 20, it is preferable to use Au, Ag, Al, Cu, or an alloy containing any of those metals, but not limited thereto. To improve the power collectivity, the surface electrode may penetrate the antireflection layer 20 and may directly contact the photoelectric conversion layer 30.

The photoelectric conversion layer 30 preferably has a p-n junction in which a p-type semiconductor and an n-type semiconductor join with each other, and can convert light energy from the sun to electric energy by the photovoltaic power effect of the p-n junction. For the photoelectric conversion layer 30, it is preferable to use single-crystal silicon, polysilicon, group-IV semiconductor, or the like, but not limited thereto.

The surface and/or the back surface of the photoelectric conversion layer 30 may have a texture structure for increasing the optical path length in the light conversion layer by scattering incident light and reflection light.

The transparent thin film layer 40 is provided on the side opposite to the light reception surface side of the photoelectric conversion layer 30 and has transparency in the wavelength region of light received by the photoelectric conversion layer 30. That is, the band gap of the transparent thin film layer 40 is desired to be larger than the band gap of the photoelectric conversion layer 30. From the viewpoint of improvement in power collectivity, the transparent thin film layer 40 preferably has conductivity. The material of the transparent thin film layer 40 may include calcium fluoride, magnesium fluoride, barium fluoride, lithium fluoride, sapphire, alumina, crystal, fluorine resin, $SnO_2$, FTO (fluorine-doped tin oxide), ITO, ZnO, $SiO_2$, $TiO_2$, $ZrO_2$, $Mn_3O_4$, $Y_2O_3$, $WO_3$, $Nb_2O_5$, $La_2O_3$, $Ga_2O_3$, $Ag_2O$, CuO, a-Si:H, μc-Si:H, $SiO_x$:H, SiC, $SiN_x$, $AlO_x$:H, polyethylene terephthalate, polycarbonate, polymethylmethacrylate, polyethylene, polypropylene, ethylene vinyl acetate copolymer, polystyrene, polyimide, polyamide, polybutylene terephthalate, polyethylene naphthalate, polysulfone, polyether sulfone, polyether ether ketone, polyvinyl alcohol, polyvinyl chloride, polyvinylidene chloride, triacetyl cellulose, polyurethane, cycloolefin polymer, and the like, but not limited thereto. The thickness of the transparent thin film layer 40 is preferably 200 nm or less. The configuration with transparent thin film layer 40 is an arbitrary one, and a configuration without the transparent thin film layer 40 can be also employed.

The light reflection layer 50 includes the metal film 52 stacked on the transparent thin film layer 40. In a plurality of places in the metal film 52, penetration parts 54 penetrating from one main surface of the film to the other main surface are provided. The opening shape of the penetration part 54 when the metal film 52 is seen from above is a circular shape. However, the opening shape of the penetration part 54 is not limited to the circular shape but may be an oval shape, a triangle shape, a square shape or the like.

The light reflection layer 50 has the function of making light which is not absorbed by the photoelectric conversion layer 30 scattered and reflected so that the light is absorbed by the photoelectric conversion layer 30. Thus, the average reflectance of the light reflection layer 50 is preferably 40% or higher, more preferably, 45% or higher, and further more preferably, 50% or higher at the range of 400 nm to the maximum wavelength usable for power generation by the photoelectric conversion layer 30, the range being included in the visible light range.

The material of the metal film 52 as a component of the light reflection layer 50 may be any metal material but, preferably, a material whose resonance wavelength in the Frohlich mode (refer to Bohren and Huffman, Absorption and Scattering of Light by Small Particles, Wiley, 1983) is close to the wavelength of the light to be subjected to photoelectric conversion. Examples of the materials satisfying this condition include Au, Ag, Al, Cu, and alloys containing those metals.

Although a thickness D of the light reflection layer 50 is not limited, it is preferably 5 to 1,000 nm, more preferably, 5 to 500 nm, and further more preferably, 5 to 300 nm. Further, the thickness D of the light reflection layer 50 preferably satisfies $D \leq B$ (B denotes maximum distance which will be described later).

In an embodiment, a distance P between the center of gravity in an opening on the photoelectric conversion layer side of an arbitrary penetration part 54 and the center of gravity in an opening of the photoelectric conversion side of another penetration part 54 adjacent to the arbitrary penetration part 54 is preferably 200 to 400 nm, more preferably, 250 to 400 nm, and further more preferably, 250 to 350 nm.

The ratio of the numbers of the above-described distance P in the range of 200 to 400 nm is preferably 30% to 100%, more preferably, 50% to 100% and, further more preferably, 70% to 100%.

The shortest distance between the adjacent penetration parts 54 in the main surface of the metal film 52 on the photoelectric conversion layer side is preferably 200 to 400 nm.

Further, in an embodiment, a maximum distance B between two points in the inner wall of the penetration part 54 in an opening on the photoelectric conversion layer side of the penetration part 54 is preferably 10 to 250 nm, more preferably, 10 to 200 nm, and further more preferably, 50 to 200 nm. The maximum distance B is the length of the diameter in the case where the shape of a section in a direction orthogonal to the penetration direction of the penetration part 54 is an exact circle, is the length of the major axis in the case of an oval shape, and is the length of a diagonal line in the case of a square.

The ratio of numbers of the maximum distance B in the range of 10 to 250 nm to the plurality of penetration parts 54 is, preferably, 30% to 100%, more preferably, 50% to 100% and, further more preferably, 70% to 100%.

When the total area of the light reflection layer 50 is defined as F and the area of the portion of the penetration parts 54 is defined as G, the content ratio of the portion of the penetration parts 54 in the light reflection layer 50 is defined by the following equation (A).

$$\text{Content ratio (\%) of portion of penetration parts 54} = G/F \times 100 \quad \ldots\ldots(A)$$

The content ratio (%) of the portion of the penetration parts 54 is preferably 30% to 80%, more preferably, 50% to 80% and, further more preferably, 60% to 80%.

Methods of forming the metal film 52 in which the penetration parts 54 are formed may include the nanosphere lithography method, the electron beam lithography method, the nanoimprint lithography method, process of a metal film with a focused ion beam, and the like.

Further, in an embodiment, in the case of using a mask for forming the metal film 52 in which the penetration parts 54 are formed, the mask may be left in the photoelectric conversion element without being removed. The mask is, for example, a film formed of particles in the nanosphere lithography method, and a film made of a resist material in the electron beam lithography method and the nanoimprint lithography method. By not removing the mask, the process of manufacturing the photoelectric conversion element can be simplified and, further reduction in the manufacture cost of the photoelectric conversion element can be expected.

The dielectric layer 60 is provided on the side opposite to the light reception surface side of the light reflection layer 50 and has transparency in the wavelength region of light received by the photoelectric conversion layer 30. That is, the band gap of the dielectric layer 60 is desired to be larger than the band gap of the photoelectric conversion layer 30. From the viewpoint of improvement in power collectivity, the dielectric layer 60 preferably has conductivity. The material of the dielectric layer 60 may include calcium fluoride, magnesium fluoride, barium fluoride, lithium fluoride, sapphire, alumina, crystal, fluorine resin, $SnO_2$, FTO (fluorine-doped tin oxide), ITO, ZnO, $SiO_2$, $TiO_2$, $ZrO_2$, $Mn_3O_4$, $Y_2O_3$, $WO_3$, $Nb_2O_5$, $La_2O_3$, $Ga_2O_3$, $Ag_2O$, CuO, a-Si:H, $\mu$c-Si:H, $SiO_x$:H, SiC, $SiN_x$, $AlO_x$:H, polyethylene terephthalate, polycarbonate, polymethylmethacrylate, polyethylene, polypropylene, ethylene vinyl acetate copolymer, polystyrene, polyimide, polyamide, polybutylene terephthalate, polyethylene naphthalate, polysulfone, polyether sulfone, polyether ether ketone, polyvinyl alcohol, polyvinyl chloride, polyvinylidene chloride, triacetyl cellulose, polyurethane, cycloolefin polymer, and the like, but not limited thereto. The thickness of the dielectric layer 60 is preferably 0 to 2,000 nm, more preferably, 0 to 1,000 nm, and further more preferably, 0 to 500 nm, but not limited thereto. The configuration with the dielectric layer 60 is an arbitrary one, and a configuration without the dielectric layer 60 can be also employed.

By covering the light reflection layer 50 with the dielectric layer 60, exposure of the light reflection layer 50 to air and water is suppressed. Consequently, stability of the light reflection layer 50 can be increased.

For the back-surface electrode formed on the side opposite to the light reception surface side of the dielectric layer 60, it is preferable to use Au, Ag, Al, Cu, or an alloy containing any of those metals, and multiple layers of the metals or alloys may be stacked.

In an embodiment, the light reflection layer 50 may also serve as a back-surface electrode for power collection. In this case, the dielectric layer 60 and the back-surface electrode formed on the side opposite to the light reception surface side of the dielectric layer 60 are unnecessary, so that the process of manufacturing the photoelectric conversion element can be simplified and, further reduction of the manufacture cost of the photoelectric conversion element can be expected.

In the above-described photoelectric conversion element 10, incident light which cannot be absorbed by the photoelectric conversion layer 30 is scattered and reflected by the light reflection layer 50 provided on the side opposite to the light reception side of the photoelectric conversion layer 30, so that the optical path length of the incident light in the photoelectric conversion layer 30 becomes longer, and the incident light can be efficiently absorbed.

Method of Fabricating Photoelectric Conversion Element

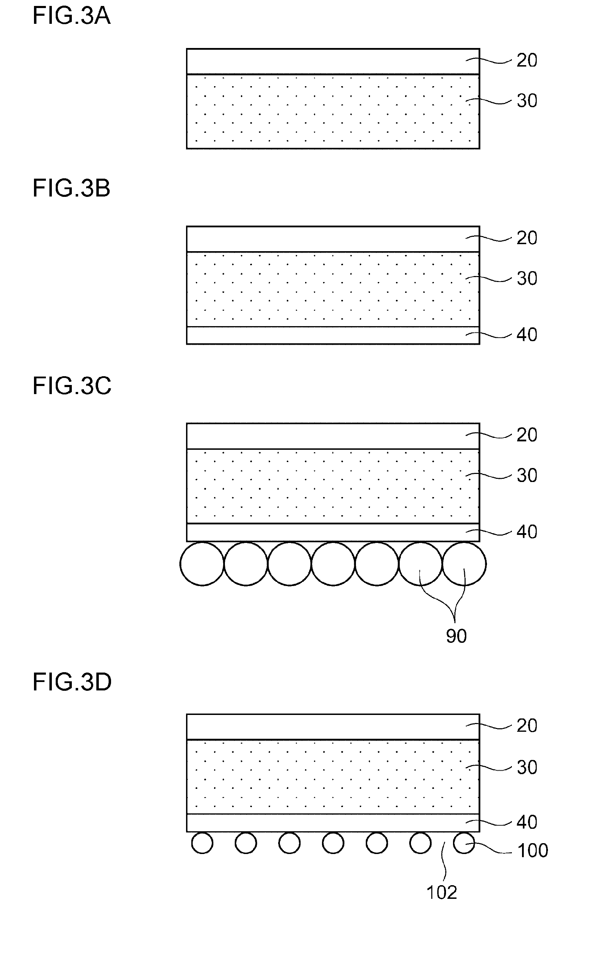

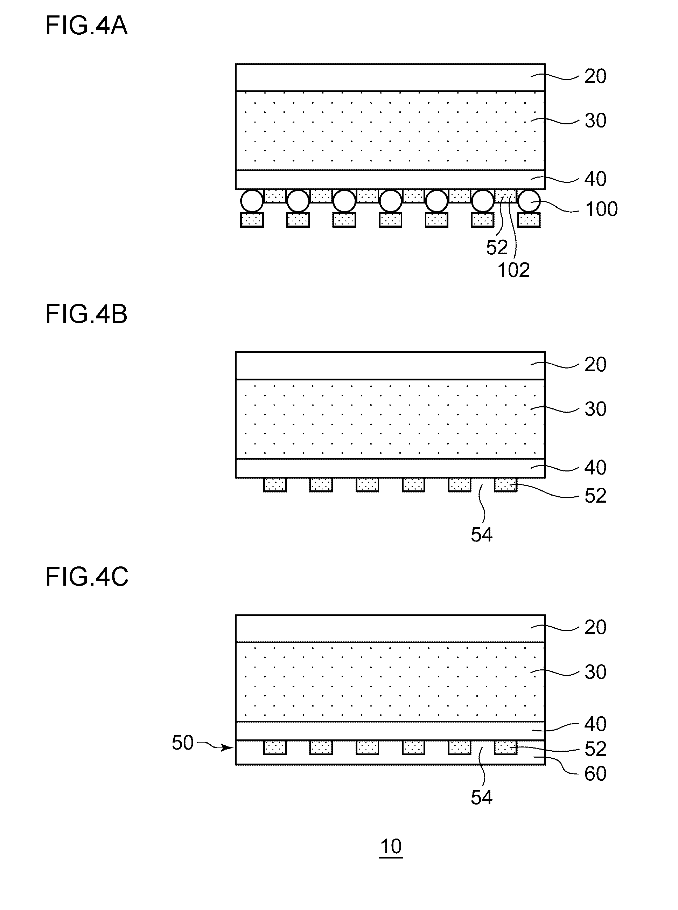

FIGS. 3(A) to 3(D) and FIGS. 4(A) to 4(C) are process cross sections illustrating a method of fabricating the photoelectric conversion element according to the first embodiment. Hereinafter, with reference to FIGS 3(A) to 3(D) and FIGS. 4(A) to 4(C), a method of fabricating a photoelectric conversion element will be described.

The photoelectric conversion layer 30 includes a p-type single crystal Si substrate, and a p-n junction is preliminarily formed by a known method such as a thermal diffusion method, an ion implantation method, a vacuum film deposition method. First, as illustrated in FIG. 3(A), the antireflection layer 20 having a thickness of 50 to 200 nm is stacked on the light reception surface side of the photoelectric conversion layer 30. The method of stacking the antireflection layer 20 is not limited, but may include, for example, a method of forming a transparent material such as $SiN_x$, ITO, or the like by the vacuum film deposition method.

Next, as illustrated in FIG. 3(B), the transparent thin film layer 40 having a thickness of 200 nm or less is stacked on the side opposite to the light reception surface of the photoelectric conversion layer 30. The method of stacking the transparent thin film layer 40 is not limited, but may include, for example, a method of forming a transparent material such as $SiO_2$, a-Si:H, $\mu$c-Si:H, $SiO_x$:H, SiC, or the like by the vacuum film deposition method.

Hereinafter, the process of forming the light reflection layer 50 (metal film 52) will be described. Concretely, a method of forming the metal film 52 by using the nanosphere lithography method will be described as an embodiment. As illustrated in FIG. 3(C), a single-layer film made of particles 90 such as, for example, polystyrene (hereinbelow, written as PS) beads, silica beads, or acrylic beads is formed on the side opposite to the light reception surface of the transparent thin film layer 40.

Next, as illustrated in FIG. 3(D), the single-layer film made of the particles 90 formed as illustrated in FIG. 3(C) is subjected to an etching process or UV process using, for example, oxygen, hydrogen gas, a gas containing oxygen or the hydrogen gas to adjust the particles to have a desired size. The single-layer film of the etched particles becomes a mask 100 used for forming the above-described metal film 52. Opening parts 102 from which the transparent thin film layer 40 is exposed are formed between the neighboring masks 100.

As illustrated in FIG. 4(A), a metal such as Ag, Al, Au, Cu and an alloy containing any of those metals is deposited by the vacuum film deposition method on the side opposite to the light reception surface of the transparent thin film layer 40 via the mask 100. The metal film 52 is formed by depositing the metal on the side opposite to the light reception surface of the transparent thin film layer 40 via openings 102. After that, as illustrated in FIG. 4(B), when the mask 100 is removed, the penetration parts 54 are formed in the metal film 52. The distance A between the center of gravity of a penetration part 54 and the center of gravity of an adjacent penetration part 54 when the transparent thin film layer 40 is seen from above is specified by the diameter of the particle forming the single-layer film in FIG. 3(C), and the maximum distance B of the penetration parts 54 is specified by the diameter of the etched particle in FIG. 3(D).

As illustrated in FIG. 4(C), the dielectric layer 60 is stacked so as to cover the surface of the light reflection layer 50. The method of stacking the dielectric layer 60 is not limited, but may include, like the method of fabricating the antireflection layer 20, for example, a method of forming a film by using a dielectric material such as ZnO, ITO by the vacuum film deposition method.

By the above-described processes, the photoelectric conversion element 10 for carrying out the present invention can be formed simply and, further, the manufacture cost of the photoelectric conversion element can be reduced.

Example 1

Hereinafter, the first embodiment of the present invention will be concretely described on the basis of examples.

Example 1-1

Fabrication of Photoelectric Conversion Layer

a-Si:H having a thickness of 5 nm was stacked as an i-layer on the light reception surface side of a p-type silicon wafer (resistivity: 0.5 to 5 $\Omega$cm) having a thickness of 100 $\mu$m and, further, n-type a-Si:H having a thickness of 7.5 nm was stacked on the i-layer, thereby fabricating a photoelectric conversion layer.

Fabrication of Antireflection Layer

A film of ITO having a thickness of 75 nm was formed as an antireflection layer on the n-type a-Si:H of the photoelectric conversion layer 30.

Fabrication of Transparent Thin Film Layer

On the side opposite to the n-type a-Si:H layer of the photoelectric conversion layer 30, a film of p-type micro-crystalline SiO$_x$:H was formed by 30 nm as a transparent thin film layer.

Fabrication of Light Reflection Layer

On the side opposite to the light reception surface of the transparent thin film layer 40, a single-layer film made of PS beads having a diameter of 300 nm was formed, and the size of the PS bead was adjusted to 250 nm by etching using O$_2$ gas, thereby fabricating the mask 7. After that, Ag was deposited by 100 nm on the side opposite to the light reception surface of the transparent thin film layer via the mask 7. The mask 7 was removed to fabricate a light reflection layer.

Fabrication of Dielectric Layer

A film of ZnO having a thickness of 200 nm was formed as a dielectric layer on the side opposite to the light reception surface side of the light reflection layer 50.

Fabrication of Electrode

A thin-wire electrode was formed by using Ag on the light reception surface side of the antireflection layer. A whole-surface electrode was formed by using Ag on the side opposite to the light reception surface side of the dielectric layer 60.
By the processes, the photoelectric conversion element (solar cell) of the example 1-1 was fabricated.

Example 1-2

A solar cell of the example 1-2 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 200 nm by etching using O$_2$ gas, thereby fabricating a mask. After that, Ag was deposited by 100 nm on the side opposite to the light reception surface of the transparent thin film layer 40 via the mask. The mask was removed to fabricate the light reflection layer 50.

Example 1-3

A solar cell of the example 1-3 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 100 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Example 1-4

A solar cell of the example 1-4 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 10 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Example 1-5

A solar cell of the example 1-5 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 30 nm by etching using $O_2$ gas, thereby fabricating a mask. After that, Ag was deposited by 100 nm on the side opposite to the light reception surface of the transparent thin film layer via the mask. The mask was removed to fabricate the light reflection layer 50.

Example 1-6

A solar cell of the example 1-6 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 50 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Example 1-7

A solar cell of the example 1-7 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 200 nm was formed, and the size of the PS bead was adjusted to 100 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Example 1-8

A solar cell of the example 1-8 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 400 nm was formed, and the size of the PS bead was adjusted to 200 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Example 1-9

A solar cell of the example 1-9 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 200 nm by etching using $O_2$ gas, thereby fabricating a mask. After that, Au was deposited by 100 nm on the side opposite to the light reception surface of the transparent thin film layer via the mask. The mask was removed to fabricate the light reflection layer.

Example 1-10

A solar cell of the example 1-10 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 200 nm by etching using $O_2$ gas, thereby fabricating a mask. After that, Al was deposited by 100 nm on the side opposite to the light reception surface of the transparent thin film layer via the mask. The mask was removed to fabricate the light reflection layer.

Example 1-11

A solar cell of the example 1-11 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 300 nm was formed, and the size of the PS bead was adjusted to 200 nm by etching using $O_2$ gas, thereby fabricating a mask. After that, Cu was deposited by 100 nm on the side opposite to the light reception surface of the transparent thin film layer via the mask. The mask was removed to fabricate the light reflection layer.

Example 1-12

A solar cell of the example 1-12 has a device structure in which a light reflection layer also serves as a back-surface electrode and has a structure obtained by eliminating the dielectric layer from the device structure of the example 1-1. A device manufacturing procedure is similar to that of the example 1-1 except that the dielectric layer is not formed.

Comparative Example 1-1

A solar cell of the comparative example 1-1 has a device structure in which an Ag film is used as a light reflection layer, and the light reflection layer also serves as a back-surface electrode. Fabricating processes until a transparent thin film layer are similar to those of the example 1-1.

Fabrication of Light Reflection Layer

Ag was deposited by 100 nm on the side opposite to the light reception surface of the transparent thin film layer without making a mask, thereby fabricating a light reflection layer.

Comparative Example 1-2

A solar cell of the comparative example 1-2 was fabricated by a procedure similar to that of the example 1-1 except for the method of fabricating a light reflection layer.

Fabrication of Light Reflection Layer

On the side opposite to the light reception surface of the transparent thin film layer, a single-layer film made of PS beads having a diameter of 300 nm was formed, thereby fabricating a mask. After that, Ag was deposited by 100 nm on the side opposite to the light reception surface of the transparent thin film layer via the mask. The mask was removed to fabricate the light reflection layer.

Comparative Example 1-3

A solar cell of the comparative example 1-3 was fabricated by a procedure similar to that of the example 1-1 except for the method of fabricating the light reflection layer.

Fabrication of Light Reflection Layer

On the side opposite to the light reception surface of the transparent thin film layer 40, a single-layer film made of PS beads having a diameter of 150 nm was formed, and the size of the PS bead was adjusted to 100 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Comparative Example 1-4

A solar cell of the comparative example 1-4 was fabricated by a procedure similar to that of the example 1-1 except for the method of fabricating the light reflection layer.

Fabrication of Light Reflection Layer

On the side opposite to the light reception surface of the transparent thin film layer, a single-layer film made of PS beads having a diameter of 450 nm was formed, and the size of the PS bead was adjusted to 200 nm by etching using $O_2$ gas, thereby fabricating a mask. After that, Ag was deposited by 100 nm on the side opposite to the light reception surface of the transparent thin film layer via the mask. The mask was removed to fabricate the light reflection layer.

Measurement of Reflectance

To measure the reflectance of each of the light reflection layers, the light reflection layers used in the examples 1-1 to 1-12 and the comparative examples 1-1 to 1-4 were formed on a single-crystal silicon wafer. The reflectance of the light reflectance layer was measured by emitting light having a wavelength of 400 nm to 1,200 nm as a light absorption end of single-crystal silicon from the light reflection layer side of the silicon wafer. Table 1 illustrates average reflectance at the wavelengths of 400 to 1,200 nm.

Evaluation of Solar Cell Performance

The current-potential characteristic of each of the solar cells of the examples 1-1 to 1-12 and the comparative examples 1-1 to 1-4 was evaluated while emitting pseudo sunlight (100 mW/cm$^2$). Table 1 illustrates results of calculation of relative short-circuit current density of each of the solar cells of the examples 1-1 to 1-12 and the comparative examples 1-1 to 1-4 using the comparative example 1-1 as a reference sample. As illustrated in Table 1, in the solar cells of the examples 1-1 to 1-12, the short-circuit current density increases conspicuously as compared with that in each of the solar cells of the comparative examples 1-1 to 1-4, and an effect of increasing the light absorption was confirmed in the solar cells of the examples 1-1 to 1-12.

Table 1

| | PENETRATION PART | | | RELATIVE VALUE OF SHORT-CIRCUI CURRENT DENSITY | AVERAGE REFLECTANCE (%) |
| | MATERIAL | DISTANCE A | MAXIMUM DISTANCE B | | |
| | | (nm) | (nm) | | |
|---|---|---|---|---|---|
| EXAMPLE 1-1 | Ag | 300 | 250 | 1.004 | 42.3 |
| EXAMPLE 1-2 | Ag | 300 | 200 | 1.01 | 50.6 |
| EXAMPLE 1-3 | Ag | 300 | 100 | 1.006 | 68.8 |
| EXAMPLE 1-4 | Ag | 300 | 10 | 1.001 | 88.2 |
| EXAMPLE 1-5 | Ag | 300 | 30 | 1.008 | 84.1 |
| EXAMPLE 1-6 | Ag | 300 | 50 | 1.01 | 79.1 |
| EXAMPLE 1-7 | Ag | 200 | 100 | 1.004 | 51.8 |
| EXAMPLE 1-8 | Ag | 400 | 200 | 1.003 | 61.3 |
| EXAMPLE 1-9 | Au | 300 | 200 | 1.007 | 46.3 |
| EXAMPLE 1-10 | Al | 300 | 200 | 1.003 | 41.7 |
| EXAMPLE 1-11 | Cu | 300 | 200 | 1.001 | 40.5 |
| EXAMPLE 1-12 | Ag | 300 | 200 | 1.01 | 50.8 |
| COMPARATIVE EXAMPLE 1-1 | - | - | - | 1 | 94.2 |
| COMPARATIVE EXAMPLE 1-2 | Ag | 300 | 300 | 0.974 | 35.6 |
| COMPARATIVE EXAMPLE 1-3 | Ag | 150 | 100 | 0.972 | 28.7 |
| COMPARATIVE EXAMPLE 1-4 | Ag | 450 | 200 | 0.994 | 64.4 |

The present invention is not limited to the foregoing embodiments and modifications such as various design changes can be added on the basis of the knowledge of a person skilled in the art, and an embodiment to which such a change is added can be also included in the scope of the present invention.

For example, in the foregoing embodiments, the p-n junction is formed in the photoelectric conversion layer 30. However, the photoelectric conversion layer 30 may have a structure capable of performing photoelectric conversion and a p-i-n junction may be formed therein.

Second Embodiment

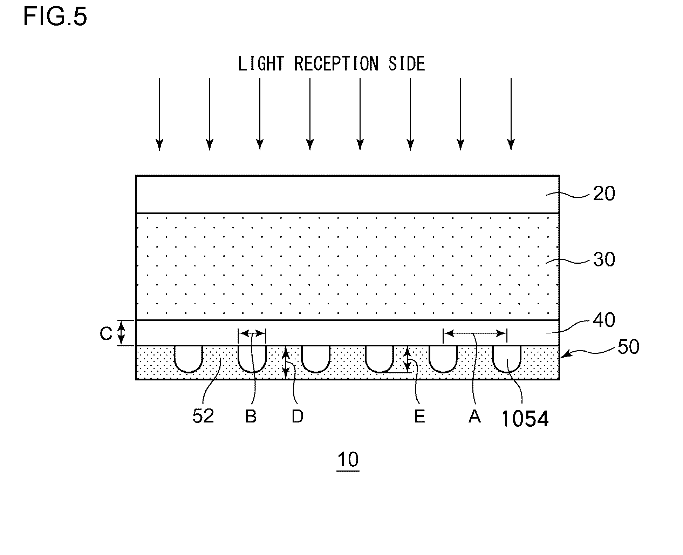

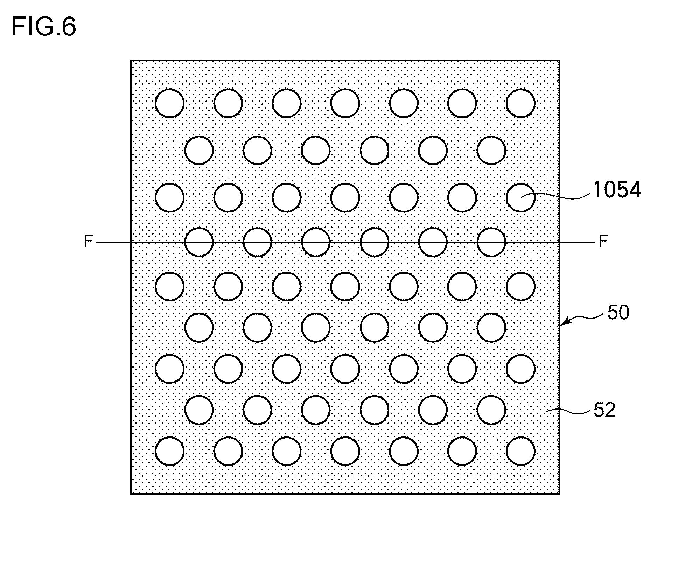

FIG. 5 is a schematic cross section illustrating the configuration of a photoelectric conversion element 10 according to a second embodiment. FIG. 6 is a plan view illustrating a form of a metal film 52 when the photoelectric conversion element 10 according to the second embodiment is seen from a light reception surface side. FIG. 5 corresponds to a cross section on the F-F line of FIG. 6. In FIG. 6, configurations of the photoelectric conversion layer 30 and the like other than the metal film 52 are omitted. As illustrated in FIG. 5, the photoelectric conversion element 10 has the antireflection layer 20, the photoelectric conversion layer 30, the transparent thin film layer 40, the light reflection layer 50, a surface electrode (not illustrated) for power collection formed on the light reception surface side of the antireflection layer 20 and, in some cases, a back-surface electrode (not illustrated) for power collection formed on the side opposite to the light reception surface side of the light reflection layer 50. In this embodiment, the photoelectric conversion element is a solar cell.

The antireflection layer 20 is provided on the light reception surface side of the photoelectric conversion layer 30. It is sufficient for the antireflection layer 20 to have transparency in the wavelength region of light received by the photoelectric conversion layer 30 and the function of preventing reflection of light received by the photoelectric conversion layer 30. The antireflection layer 20 is preferably made of $SiO_2$, $SiN_x$, $TiO_2$, ITO, or the like, but not limited thereto.

The thickness of the antireflection layer 20 is preferably 0 to 500 nm, more preferably, 0 to 300 nm, and further more preferably, 50 to 200 nm, but not limited thereto.

For the surface electrode formed on the light reception surface side of the antireflection layer 20, it is preferable to use Au, Ag, Al, Cu, or an alloy containing any of those metals, but not limited thereto. To improve the power collectivity, the surface electrode may penetrate the antireflection layer 20 and may directly contact the photoelectric conversion layer 30.

The photoelectric conversion layer 30 preferably has at least a p-n junction in which a p-type semiconductor and an n-type semiconductor join with each other, and can convert light energy from the sun to electric energy by the photovoltaic power effect of the p-n junction. For the photoelectric conversion layer 30, it is preferable to use single-crystal silicon, polysilicon, amorphous silicon, microcrystalline silicon, group-IV semiconductor, or the like, but not limited thereto.

The surface and/or the back surface of the photoelectric conversion layer 30 may have a texture structure for increasing the optical path length in the light conversion layer by scattering incident light and reflection light.

The transparent thin film layer 40 is provided on the side opposite to the light reception surface side of the photoelectric conversion layer 30 and has transparency in the wavelength region of light received by the photoelectric conversion layer 30. That is, the band gap of the transparent thin film layer 40 is desired to be larger than the band gap of the photoelectric conversion layer 30. From the viewpoint of improvement in power collectivity, the transparent thin film layer 40 preferably has conductivity. The material of the transparent thin film layer 40 may include calcium fluoride, magnesium fluoride, barium fluoride, lithium fluoride, sapphire, alumina, crystal, fluorine resin, $SnO_2$, FTO (fluorine-doped tin oxide), ITO, ZnO, $SiO_2$, $TiO_2$, $ZrO_2$, $Mn_3O_4$, $Y_2O_3$, $WO_3$, $Nb_2O_5$, $La_2O_3$, $Ga_2O_3$, $Ag_2O$, CuO, a-Si:H, μc-Si:H, $SiO_x$:H, SiC, $SiN_x$, $AlO_x$:H, polyethylene terephthalate, polycarbonate, polymethylmethacrylate, polyethylene, polypropylene, ethylene vinyl acetate copolymer, polystyrene, polyimide, polyamide, polybutylene terephthalate, polyethylene naphthalate, polysulfone, polyether sulfone, polyether ether ketone, polyvinyl alcohol, polyvinyl chloride, polyvinylidene chloride, triacetyl cellulose, polyurethane, cycloolefin polymer, and the like, but not limited thereto. The configuration with the transparent thin film layer 40 is an arbitrary one, and a configuration without the transparent thin film layer 40 can be also employed.

The light reflection layer 50 includes the metal film 52 stacked on the transparent thin film layer 40. A plurality of concave parts 1054 is provided in a main surface on the side of the photoelectric conversion layer 30 of the metal film 52. The opening shape of the concave part 1054 when the metal film 52 is seen from above is a circular shape. However, the opening shape of the concave part 1054 is not limited to the circular shape but may be an oval shape, a triangle shape, a square shape or the like.

The material of the metal film 52 as a component of the light reflection layer 50 may be any metal material but, preferably, a material whose resonance wavelength in the Frohlich mode (refer to Bohren and Huffman, Absorption and Scattering of Light by Small Particles, Wiley, 1983) is close to the wavelength of the light to be subjected to photoelectric conversion. Examples of the materials satisfying this condition include Au, Ag, Al, Cu, and alloys containing those metals.

Although a thickness D of the light reflection layer 50 is not limited, it is larger than a depth E of the concave part 1054, that is, D > E. The thickness D is preferably 5 to 2,000 nm, more preferably, 5 to 1,000 nm, and further more preferably, 5 to 500 nm.

In an embodiment, the distance A between the center of gravity in an opening of an arbitrary concave part 1054 and the center of gravity in an opening of another concave part 1054 adjacent to the arbitrary concave part 1054 is preferably 250 to 450 nm, more preferably, 250 to 400 nm, and further more preferably, 250 to 350 nm.

The ratio of the numbers of the above-described distance A in the range of 250 to 400 nm is preferably 30% to 100%, more preferably, 50% to 100% and, further more preferably, 70% to 100%.

Further, in an embodiment, a maximum distance B between two points in an inner wall of the concave part 1054 in an opening on the concave part 1054 is preferably 50 to 350 nm, more preferably, 50 to 300 nm, and further more preferably, 100 to 250 nm. The maximum distance B is the length of the diameter in the case where the shape of a section when the opening of the concave part 1054 is seen from above is an exact circle, is the length of the major axis in the case of an oval shape, and is the length of a diagonal line in the case of a square or rectangle shape. In the photoelectric conversion element 10 illustrated in FIG. 5, the bottom of the concave part 1054 is curved. The sectional shape of the concave part 1054, however, is not limited to the curved shape but may be a rectangular shape.

The ratio of numbers of the maximum distance B in the range of 50 to 350 nm in the plurality of concave parts 1054 is, preferably, 30% to 100%, more preferably, 50% to 100% and, further more preferably, 70% to 100%.

When the total area of the light reflection layer 50 is defined as G and the area of the metal film 52 in which the concave parts 1054 are formed is defined as H, the content ratio of the portion of the metal film 52 in the light reflection layer 50 is defined by the following equation (A).

$$\text{Content ratio (\%) of portion of metal film 52} = H/G \times 100$$

$$\ldots\ldots \text{(A)}$$

It is more preferable to have the higher the content ratio of the portion of the metal film 52. Concretely, it is preferably to have 30% to 80%, more preferably, 50% to 80% and, further more preferably, 60% to 80% of the content ratio.

Methods of forming the metal film 52 in which the concave parts 1054 are formed include the nanosphere lithography method, the electron beam lithography method, the nanoimprint lithography method, process of a metal film with a focus ion beam, and the like.

In an embodiment of the present invention, it is desirable to fabricate the light reflection layer 50 after the photoelectric conversion layer 30 is fabricated. In the case of fabricating the photoelectric conversion layer 30 after the light reflection layer 50 is fabricated, the same concavity and convexity as that in the light reflection layer 50 is formed also in the photoelectric conversion layer 30. Therefore, the probability that electrons are trapped in the photoelectric conversion layer 30 increases, and this may deteriorate the device performance. On the other hand, in the case of fabricating the light reflection layer 50 after fabrication of the photoelectric conversion layer 30, no concavity or convexity is formed in the photoelectric conversion layer 30, so that there is no above-described problem.

Further, in an embodiment of the present invention, in the case of using a mask for forming the metal film 52 in which the concave parts 1054 are formed, the mask may be left in the photoelectric conversion element without being removed. The mask is, for example, a film formed of particles in the nanosphere lithography method, and a film made of a resist material in the electron beam lithography method and the nanoimprint lithography method. By not removing the mask, the process of manufacturing the photoelectric conversion element can be simplified and, further reduction in the manufacture cost of the photoelectric conversion element can be expected.

For the back-surface electrode formed on the side opposite to the light reception surface side of the light reflection layer 50, it is preferable to use Au, Ag, Al, Cu, or an alloy containing any of those metals, and multiple layers of the metals or the alloys containing the metals may be stacked.

In an embodiment, the light reflection layer 50 may also serve as a back-surface electrode for power collection. In this case, the back-surface electrode formed on the side opposite to the light reception surface side of the light reflection layer 50 are unnecessary, so that the process of manufacturing the photoelectric conversion element can be simplified and, further reduction of the manufacture cost of the photoelectric conversion element can be expected.

In the above-described photoelectric conversion element 10, incident light which cannot be absorbed by the photoelectric conversion layer 30 is scattered and reflected by the light reflection layer 50 having at least a metal hole, the layer 50 being provided on the side opposite to the light reception side of the photoelectric conversion layer 30, so that the optical path length of the incident light in the photoelectric conversion layer 30 becomes longer, and the incident light can be efficiently absorbed.

Modification

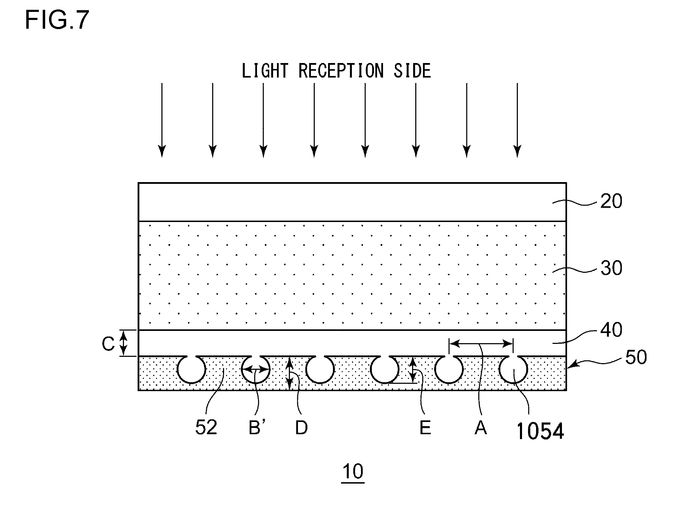

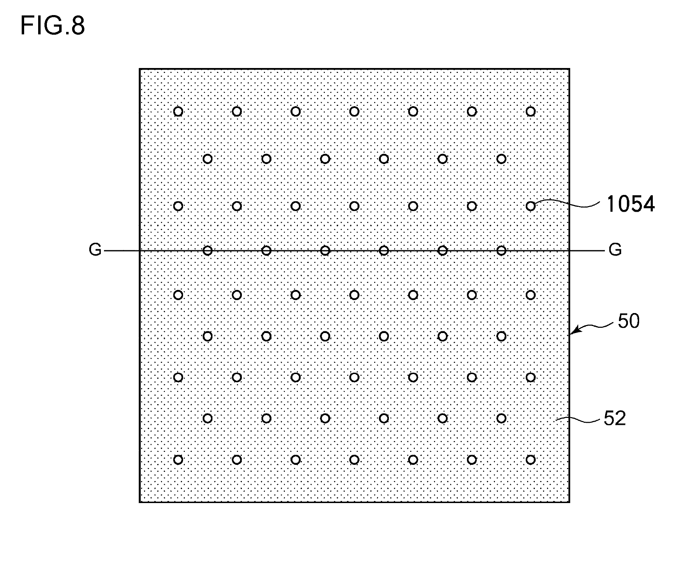

FIG. 7 is a schematic cross section illustrating the configuration of the photoelectric conversion element 10 according to a modification. FIG. 8 is a plan view illustrating a form of the metal film 52 when the photoelectric conversion element 10 according to the modification is seen from the light reception surface side. FIG. 7 corresponds to a cross section on the G-G line of FIG. 8. In FIG. 8, configurations of the photoelectric conversion layer 30 and the like other than the metal film 52 are omitted. The concave part 1054 has a spherical shape, and the area of the opening of the concave part 1054 which is in contact with the light reflection layer 50 is not the maximum in the sectional area of the concave part 1054 in an arbitrary section parallel to the main face of the metal film 52. In such a case, a maximum distance B' between two points in an inner wall of the concave part in a section where the sectional area of the concave part 1054 is maximum is preferably 50 to 350 nm, more preferably 50 to 300 nm, and further more preferably, 100 to 250 nm.

Method of Fabricating Photoelectric Conversion Element

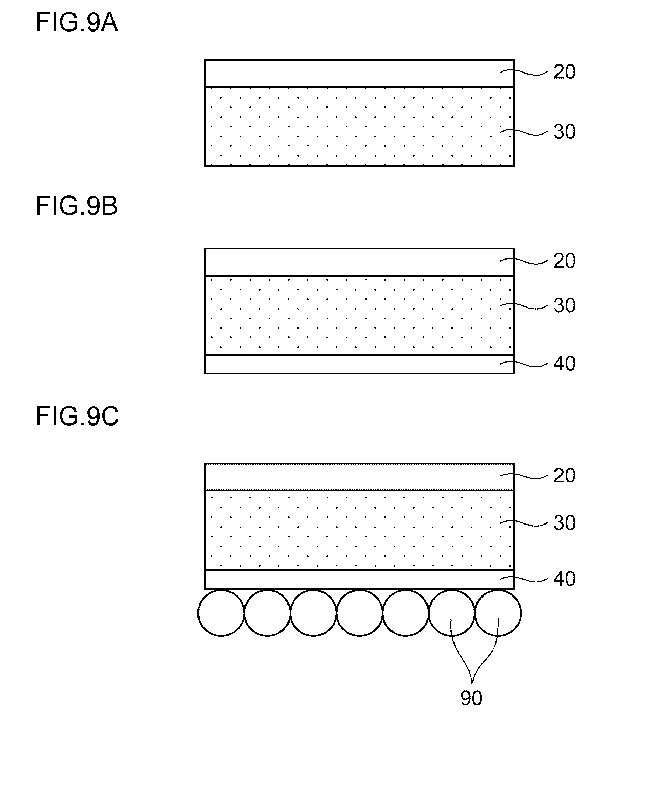

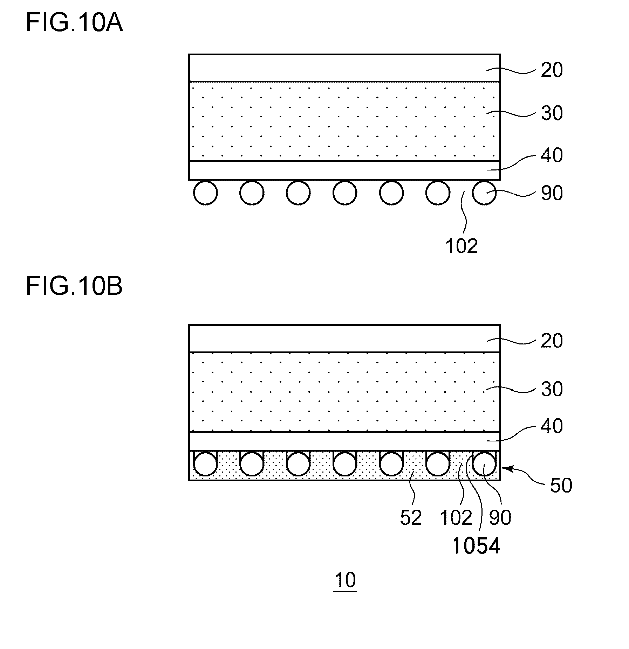

FIGS. 9(A) to 9(C) and FIGS. 10(A) and 10(B) are process cross sections illustrating fabricating processes of the photoelectric conversion element according to the second embodiment. Hereinafter, with reference to FIGS. 9(A) to 9(C) and FIGS. 10(A) and 10(B), a method of fabricating the photoelectric conversion element will be described.

The photoelectric conversion layer 30 includes a p-type single crystal Si substrate, and a p-n junction is preliminarily formed by a known methods such as a thermal diffusion method, an ion implantation method, a vacuum film deposition method. First, as illustrated in FIG. 9(A), the antireflection layer 20 having a thickness of 50 to 200 nm is stacked on the light reception surface side of the photoelectric conversion layer 30. The method of stacking the antireflection layer 20 is not limited, but may include, for example, a method of forming a transparent material such as $SiN_x$, ITO, or the like by the vacuum film deposition method.

Next, as illustrated in FIG. 9(B), the transparent thin film layer 40 having a thickness of 200 nm or less is stacked on the side opposite to the light reception surface of the photoelectric conversion layer 30. The method of stacking the transparent thin film layer 40 is not limited, but may include, for example, a method of forming a transparent material such as $SiO_2$, a-Si:H, μc-Si:H, $SiO_x$:H, SiC, or the like by the vacuum film deposition method.

Hereinafter, the process of forming the light reflection layer 50 (metal film 52) will be described. Concretely, a method of forming a metal hole by using the nanosphere lithography method will be described as an embodiment. As illustrated in FIG. 9(C), a single-layer film made of particles 90 such as polystyrene (hereinbelow, written as PS) beads, silica beads, or acrylic beads is formed on the side opposite to the light reception surface of the transparent thin film layer 40. The particle 90 has transparency in the wavelength region of light received by the photoelectric conversion layer 30 like in the transparent thin film layer 40.

Next, as illustrated in FIG. 10(A), the single-layer film made of the particles 90 formed as illustrated in FIG. 9(C) is subjected to an etching process or UV process using, for example, oxygen, hydrogen gas, a gas containing oxygen or the hydrogen gas to adjust the particles to have a desired size. The single-layer film of the etched particles becomes a mask 100 used for forming a metal hole. Opening parts 102 from which the transparent thin film layer 40 is exposed are formed between the neighboring masks 100.

As illustrated in FIG. 10(B), a metal such as Ag, Al, Au, Cu or an alloy containing any of those metals is deposited by the vacuum film deposition method on the side opposite to the light reception surface of the transparent thin film layer 40 via the mask 100. By depositing the metal on the side opposite to the light reception surface of the transparent thin film layer 40 via openings 102, the metal film 52 in which the concave parts 1054 are formed, that is, the light reflection layer 50 is formed. Although the mask 100 resides in the concave part 1054, as described above, the particle 90 as the material of the mask 100 has transparency in the wavelength region of light received by the photoelectric conversion layer 30. Consequently, the light reflectance of the light reflection layer 50 is equivalent to that in the case where the entire concave part 1054 is not occupied by an object.

By the above-described process, the photoelectric conversion element 10 according to the second embodiment can be easily formed and, further, the manufacture cost of the photoelectric conversion element 10 can be reduced. When the metal film 52 is formed by using a paste metal in the process illustrated in FIG. 10(B), the metal is provided without any gap in the periphery of the mask 100, so that the photoelectric conversion element 10 of the modification can be fabricated. In this case, the entire concave part 1054 is occupied with the mask 100. However, the particle 90 as the material of the mask 100 has transparency in the wavelength region of light received by the photoelectric conversion layer 30. Therefore, the light reflectance of the light reflection layer 50 is equivalent to that in the case where the entire concave part 1054 is not occupied by an object.

Example 2

Hereinafter, a second embodiment of the present invention will be concretely described on the basis of examples.

Example 2-1

Fabrication of Photoelectric Conversion Layer

a-Si:H having a thickness of 5 nm was stacked as an i-layer on the light reception surface side of a p-type silicon wafer (resistivity 0.5 to 5 Ωcm) having a thickness of 100 μm and, further, n-type a-Si:H having a thickness of 7.5 nm was stacked on the i-layer, thereby fabricating a photoelectric conversion layer.

Fabrication of Antireflection Layer

A film of ITO having a thickness of 75 nm was formed as an antireflection layer on the n-type a-Si:H of the photoelectric conversion layer.

Fabrication of Transparent Thin Film Layer

On the side opposite to the n-type a-Si:H layer of the photoelectric conversion layer 30, a film of p-type microcrystalline Si:H was formed by 30 nm as a transparent thin film layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 50 nm by etching using $O_2$ gas, thereby fabricating a mask. After that, Ag was deposited by 5,000 nm on the side opposite to the light reception surface of the transparent thin film layer via the mask. The mask was removed to fabricate a light reflection layer. The light reflection layer also serves as a back-surface electrode for power collection. By the processes, the photoelectric conversion element (solar cell) of the example 2-1 was fabricated.

Example 2-2

A solar cell of the example 2-2 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 100 nm by etching using $O_2$ gas, thereby fabricating a mask. After that, Ag was deposited by 500 nm on the side opposite to the light reception surface of the transparent thin film layer via the mask. The mask 8 was removed to fabricate the light reflection layer.

Example 2-3

A solar cell of the example 2-3 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 150 nm by etching using $O_2$ gas, thereby fabricating a mask. After that, Ag was deposited by 500 nm on the side opposite to the light reception surface of the transparent thin film layer via the mask. The mask was removed to fabricate the light reflection layer.

Example 2-4

A solar cell of the example 2-4 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 200 nm by etching using $O_2$ gas, thereby fabricating a mask. After that, Ag was deposited by 500 nm on the side opposite to the light reception surface of the transparent thin film layer via the mask. The mask was removed to fabricate the light reflection layer.

Example 2-5

A solar cell of the example 2-5 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 250 nm by etching using $O_2$ gas, thereby fabricating a mask. After that, Ag was deposited by 500 nm on the side opposite to the light reception surface of the transparent thin film layer via the mask. The mask was removed to fabricate the light reflection layer

Example 2-6

A solar cell of the example 2-6 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 250 nm were close-packed was formed, and the size of the PS bead was adjusted to 200 nm by etching using $O_2$ gas, thereby fabricating a mask. After that, Ag was deposited by 500 nm on the side opposite to the light reception surface of the transparent thin film layer via the mask. The mask was removed to fabricate the light reflection layer.

Example 2-7

A solar cell of the example 2-7 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 400 nm were close-packed was formed, and the size of the PS bead was adjusted to 200 nm by etching using $O_2$ gas, thereby fabricating a mask. After that, Ag was deposited by 500 nm on the side opposite to the light reception surface of the transparent thin film layer via the mask. The mask was removed to fabricate the light reflection layer.

Example 2-8

A solar cell of the example 2-8 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 450 nm were close-packed was formed, and the size of the PS bead was adjusted to 200 nm by etching using $O_2$ gas, thereby fabricating a mask. After that, Ag was deposited by 500 nm on the side opposite to the light reception surface of the transparent thin film layer via the mask. The mask was removed to fabricate the light reflection layer.

Example 2-9

A solar cell of the example 2-9 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 200 nm by etching using $O_2$ gas, thereby fabricating a mask. After that, Au was deposited by 500 nm on the side opposite to the light reception surface of the transparent thin film layer via the mask. The mask was removed to fabricate the light reflection layer.

Example 1-10

A solar cell of the example 2-10 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 200 nm by etching using $O_2$ gas, thereby fabricating a mask. After that, Al was deposited by 500 nm on the side opposite to the light reception surface of the transparent thin film layer via the mask. The mask was removed to fabricate the light reflection layer.

Example 2-11

A solar cell of the example 2-11 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 300 nm were close-packed was formed, and the size of the PS bead was adjusted to 200 nm by etching using $O_2$ gas, thereby fabricating a mask. After that, Cu was deposited by 500 nm on the side opposite to the light reception surface of the transparent thin film layer via the mask. The mask was removed to fabricate the light reflection layer.

Example 2-12

A solar cell of the example 2-12 was fabricated by a device fabricating procedure similar to that of the example 2-4 except that a mask is not removed.

Comparative Example 2-1

A solar cell of the comparative example 2-1 has a device structure in which an Ag film is used as a light reflection layer, and the light reflection layer also serves as a back-surface electrode. Fabricating processes until the process of fabricating a transparent thin film layer are similar to those of the example 2-1.

Fabrication of Light Reflection Layer

Ag was deposited by 500 nm on the side opposite to the light reception surface of the transparent thin film layer without making a mask, thereby fabricating a light reflection layer.

Comparative Example 2-2

A solar cell of the comparative example 2-2 was fabricated by a procedure similar to that of the example 2-1 except for the method of fabricating a light reflection layer.

Fabrication of Light Reflection Layer

On the side opposite to the light reception surface of the transparent thin film layer, a single-layer film in which PS beads having a diameter of 150 nm were close-packed was formed, thereby fabricating a mask. After that, Ag was deposited by 500 nm on the side opposite to the light reception surface of the transparent thin film layer via the mask. The mask was removed to fabricate the light reflection layer.

Comparative Example 2-3

A solar cell of the comparative example 2-3 was fabricated by a procedure similar to that of the example 2-1 except for the method of fabricating the light reflection layer.

Fabrication of Light Reflection Layer

On the side opposite to the light reception surface of the transparent thin film layer 40, a single-layer film in which PS beads having a diameter of 450 nm were close-packed was formed, thereby fabricating a mask. After that, Ag was deposited by 500 nm on the side opposite to the light reception surface of the transparent thin film layer via the mask. The mask was removed to fabricate the light reflection layer.

Comparative Example 2-4

A solar cell of the comparative example 2-4 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 500 nm were close-packed was formed, and the size of the PS bead was adjusted to 200 nm by etching using $O_2$ gas thereby fabricating a mask. After that, Ag was deposited by 500 nm on the side opposite to the light reception surface of the transparent thin film layer via the mask. The mask was removed to fabricate the light reflection layer.

Comparative Example 2-5

A solar cell of the comparative example 2-5 was fabricated by a procedure similar to that of the example 2-1 except for the method of fabricating the light reflection layer.

Fabrication of Light Reflection Layer

On the side opposite to the light reception surface of the transparent thin film layer, a single-layer film in which PS beads having a diameter of 200 nm were close-packed was formed, and the size of the PS bead was adjusted to 150 nm by etching using $O_2$ gas, thereby fabricating a mask. After that, Ag was deposited by 500 nm on the side opposite to the light reception surface of the transparent thin film layer via the mask. The mask was removed to fabricate the light reflection layer.

Evaluation of Solar Cell Performance

The current-potential characteristic of each of the solar cells of the examples 2-1 to 2-12 and the comparative examples 2-1 to 2-5 was evaluated while emitting pseudo sunlight (100 mW/cm$^2$). Table 2 illustrates results of calculation of relative short-circuit current density of each of the solar cells of the examples 2-1 to 2-12 and the comparative examples 2-1 to 2-5 using the comparative example 2-1 as a reference sample. As illustrated in Table 2, in the solar cells of the examples 2-1 to 2-12, the short-circuit current density increases conspicuously as compared with that in each of the solar cells of the comparative examples 2-1 to 2-5, and an effect of increasing light absorption was confirmed in the solar cells of the examples 2-1 to 2-12.

Table 2

| | RECESSED PART | | | RELATIVE VALUE OF SHORT-CIRCUIT CURRENT DENSITY |
| --- | --- | --- | --- | --- |
| | MATERIAL | DISTANCE A | MAXIMUM DISTANCE B | |
| | | (nm) | (nm) | |
| EXAMPLE 2-1 | Ag | 300 | 50 | 1.001 |

(continued)

| | RECESSED PART | | | RELATIVE VALUE OF SHORT-CIRCUIT CURRENT DENSITY |
| | MATERIAL | DISTANCE A | MAXIMUM DISTANCE B | |
| | | (nm) | (nm) | |
| EXAMPLE 2-2 | Ag | 300 | 100 | 1.006 |
| EXAMPLE 2-3 | Ag | 300 | 150 | 1.009 |
| EXAMPLE 2-4 | Ag | 300 | 200 | 1.016 |
| EXAMPLE 2-5 | Ag | 300 | 250 | 1.005 |
| EXAMPLE 2-6 | Ag | 250 | 200 | 1.001 |
| EXAMPLE 2-7 | Ag | 400 | 200 | 1.004 |
| EXAMPLE 2-8 | Ag | 450 | 200 | 1.002 |
| EXAMPLE 2-9 | Au | 300 | 200 | 1.013 |
| EXAMPLE 2-10 | Al | 300 | 200 | 1.011 |
| EXAMPLE 2-11 | Cu | 300 | 200 | 1.003 |
| EXAMPLE 2-12 | Ag | 300 | 200 | 1.016 |
| COMPARATIVE EXAMPLE 2-1 | - | - | - | 1 |
| COMPARATIVE EXAMPLE 2-2 | Ag | 150 | 30 | 0.992 |
| COMPARATIVE EXAMPLE 2-3 | Ag | 450 | 400 | 0.999 |
| COMPARATIVE EXAMPLE 2-4 | Ag | 500 | 200 | 0.994 |
| COMPARATIVE EXAMPLE 2-5 | Ag | 200 | 150 | 0.996 |

The present invention is not limited to the foregoing embodiments and modification such as various design changes can be added on the basis of the knowledge of a person skilled in the art, and an embodiment to which such a change is added can be also included in the scope of the present invention.

For example, in the foregoing embodiments, the p-n junction is formed in the photoelectric conversion layer 30. However, the photoelectric conversion layer 30 may have a structure capable of performing photoelectric conversion and a p-i-n junction may be formed therein.

REFERENCE SIGNS LIST

10 photoelectric conversion element, 20 antireflection layer, 30 photoelectric conversion layer, 40 transparent thin film layer, 50 light reflection layer, 52 metal film, 54 penetration part, 60 dielectric layer, 100 mask, 102 opening, 1054 concave part

INDUSTRIAL APPLICABILITY

The present invention can be applied to a photoelectric conversion element converting light energy to electric energy by photoelectric conversion.

**Claims**

1. A photoelectric conversion element comprising:

   a photoelectric conversion layer; and
   a light reflection layer including a metal film provided on one of main surface sides of the photoelectric conversion layer, wherein
   penetration parts penetrating from one main surface of the metal film to the other main surface are provided in a plurality of portions in the metal film.

2. The photoelectric conversion element according to claim 1, wherein
   a distance between a center of gravity in an opening on the photoelectric conversion layer side of an arbitrary penetration part and a center of gravity in an opening on the photoelectric conversion side of another penetration part adjacent to the arbitrary penetration part is 200 nm to 400 nm.

3. The photoelectric conversion element according to claim 1 or 2, wherein
   in an opening on the photoelectric conversion layer side of the penetration part, a maximum distance between two points in an inner wall of the penetration part is 10 nm to 250 nm.

4. The photoelectric conversion element according to any one of claims 1 to 3, wherein
   a shortest distance between adjacent penetration parts is 200 nm to 400 nm in a main surface of the metal film on the photoelectric conversion layer side.

5. The photoelectric conversion element according to any one of claims 1 to 4, wherein
   average reflectance in a range from 400 nm to a maximum wavelength usable by the photoelectric conversion layer for power generation, of the light reflection layer is 40% or higher.

6. The photoelectric conversion element according to any one of claims 1 to 5, wherein
   the light reflection layer is provided on a side opposite to a light reception surface of the photoelectric conversion layer.

7. The photoelectric conversion element according to any one of claims 1 to 6, wherein
   the metal film is made of Au, Ag, Al, Cu, or an alloy containing any of those metals.

8. The photoelectric conversion element according to any one of claims 1 to 7, wherein
   the light reflection layer includes a mask for forming the metal film.

9. The photoelectric conversion element according to any one of claims 1 to 8, wherein
   the light reflection layer also serves as a back-surface electrode for power collection.

10. A photoelectric conversion element comprising:

    a photoelectric conversion layer;
    an antireflection layer provided on one main surface side of the photoelectric conversion layer; and
    a light reflection layer including a metal film provided on the other main surface side of the photoelectric conversion layer, wherein
    a plurality of concave parts are provided in a main surface on the side of the photoelectric conversion layer of the metal film.

11. The photoelectric conversion element according to claim 10, wherein
    a distance between a center of gravity in an opening of an arbitrary concave part and a center of gravity in an opening of another concave part adjacent to the arbitrary concave part is 250 nm to 400 nm.

12. The photoelectric conversion element according to claim 10 or 11, wherein
    the metal film is made of Au, Ag, Al, Cu, or an alloy containing any of those metals.

13. The photoelectric conversion element according to any one of claims 10 to 12, wherein
    the photoelectric conversion layer includes single crystal or polycrystalline silicon having a p-n junction.

**14.** The photoelectric conversion element according to any one of claims 10 to 13, wherein the light reflection layer includes a mask for forming the metal film.

**15.** The photoelectric conversion element according to any one of claims 10 to 14, wherein the light reflection layer also serves as a back-surface electrode for power collection.

FIG.1

LIGHT RECEPTION SIDE

20

30

40

50

60

C

52    B    D    54    A

10

FIG.2

FIG.3A

```
                                    ┌─────────────────────┐
                                    │                     │──── 20
                                    ├─────────────────────┤
                                    │ · · · · · · · · · · │──── 30
                                    │ · · · · · · · · · · │
                                    └─────────────────────┘
```

FIG.3B

```
                                    ┌─────────────────────┐
                                    │                     │──── 20
                                    ├─────────────────────┤
                                    │ · · · · · · · · · · │──── 30
                                    │ · · · · · · · · · · │
                                    ├─────────────────────┤
                                    │                     │──── 40
                                    └─────────────────────┘
```

FIG.3C

```
                                    ┌─────────────────────┐
                                    │                     │──── 20
                                    ├─────────────────────┤
                                    │ · · · · · · · · · · │──── 30
                                    │ · · · · · · · · · · │
                                    ├─────────────────────┤
                                    │                     │──── 40
                                    └─────────────────────┘
                                      ○ ○ ○ ○ ○ ○ ○
                                             90
```

FIG.3D

```
                                    ┌─────────────────────┐
                                    │                     │──── 20
                                    ├─────────────────────┤
                                    │ · · · · · · · · · · │──── 30
                                    │ · · · · · · · · · · │
                                    ├─────────────────────┤
                                    │                     │──── 40
                                    └─────────────────────┘
                                     o o o o o o o ──── 100
                                             102
```

FIG.4A

| | 20 |
| | 30 |
| | 40 |
| | 100 |
| | 52 |
| | 102 |

FIG.4B

| | 20 |
| | 30 |
| | 40 |
| | 52 |
| | 54 |

FIG.4C

| | 20 |
| | 30 |
| | 40 |
| 50 | 52 |
| | 60 |
| | 54 |

10

FIG.5

LIGHT RECEPTION SIDE

10

FIG.6

1054

50

52

FIG.7

LIGHT RECEPTION SIDE

10

FIG.8

G——————————————G

1054

50

52

FIG.9A

20

30

FIG.9B

20

30

40

FIG.9C

20

30

40

90

FIG.10A

FIG.10B

10

## INTERNATIONAL SEARCH REPORT

| International application No. |
| --- |
| PCT/JP2012/003285 |

### A. CLASSIFICATION OF SUBJECT MATTER
*H01L31/052*(2006.01)i

According to International Patent Classification (IPC) or to both national classification and IPC

### B. FIELDS SEARCHED

Minimum documentation searched (classification system followed by classification symbols)
H01L31/04-31/078

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | Microfilm of the specification and drawings annexed to the request of Japanese Utility Model Application No. 093111/1989(Laid-open No. 032445/1991) (Sanyo Electric Co., Ltd.), 29 March 1991 (29.03.1991), entire text; all drawings (Family: none) | 1-7 |
| X | JP 06-204537 A  (Canon Inc.), 22 July 1994 (22.07.1994), paragraphs [0019], [0031]; fig. 1 (Family: none) | 1-7,9 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 14 August, 2012 (14.08.12) | 28 August, 2012 (28.08.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2012/003285

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2011-114153 A (Mitsubishi Electric Corp.),<br>09 June 2011 (09.06.2011),<br>entire text; all drawings<br>(Family: none) | 10-15<br>8 |
| X | JP 05-308148 A (TDK Corp.),<br>19 November 1993 (19.11.1993),<br>paragraph [0042]; fig. 3, 53<br>(Family: none) | 10-13,15 |
| X | JP 59-205771 A (Exxon Research & Engineering Co.),<br>21 November 1984 (21.11.1984),<br>page 3, upper right column, lines 2 to 11;<br>lower left column, lines 11 to 14; fig. 1, 4<br>& US 4536608 A      & EP 127317 A1<br>& AU 2711284 A      & CA 1198801 A<br>& AU 562159 B | 10-13,15 |
| X | JP 62-209872 A (Fuji Electric Corporation Research and Development Ltd.),<br>16 September 1987 (16.09.1987),<br>entire text; all drawings<br>(Family: none) | 10-13,15 |
| A | JP 2011-109069 A (Mitsubishi Materials Corp.),<br>02 June 2011 (02.06.2011),<br>entire text; all drawings<br>& CN 102097513 A | 10-13,15 |
| P,X<br>P,A | WO 2011/138739 A2 (COMMISSARIAT A L'ENERGIE ATOMIQUE ET AUX ENERGIES ALTERNATIVES),<br>10 November 2011 (10.11.2011),<br>entire text; all drawings<br>& FR 2959872 A | 10-15<br>8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S61288473 B
- JP H4133360 B
- JP 2000294818 A
- JP 2009533875 PCT

**Non-patent literature cited in the description**

- **BOHREN ; HUFFMAN.** Absorption and Scattering of Light by Small Particles. Wiley, 1983